(19) Europäisches Patentamt
European Patent Office
Office européen des brevets

(11) **EP 1 929 538 B1**

(12) **EUROPÄISCHE PATENTSCHRIFT**

(45) Veröffentlichungstag und Bekanntmachung des Hinweises auf die Patenterteilung:
**07.12.2016 Patentblatt 2016/49**

(21) Anmeldenummer: **06793618.7**

(22) Anmeldetag: **19.09.2006**

(51) Int Cl.:
*H01L 29/872* (2006.01) *H01L 29/36* (2006.01)
*H01L 29/06* (2006.01) *H01L 29/08* (2006.01)

(86) Internationale Anmeldenummer:
**PCT/EP2006/066481**

(87) Internationale Veröffentlichungsnummer:
**WO 2007/036455 (05.04.2007 Gazette 2007/14)**

(54) **JBS-SIC-HALBLEITERBAUELEMENT**

JBS-SIC SEMICONDUCTOR COMPONENT

DISPOSITIF DE TYPE JBS A SEMI-CONDUCTEUR SIC

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **29.09.2005 DE 102005046706**

(43) Veröffentlichungstag der Anmeldung:
**11.06.2008 Patentblatt 2008/24**

(73) Patentinhaber: **Infineon Technologies AG**
**85579 Neubiberg (DE)**

(72) Erfinder:
• **MITLEHNER, Heinz**
**91080 Uttenreuth (DE)**
• **STEPHANI, Dietrich**
**91088 Bubenreuth (DE)**

(74) Vertreter: **Westphal, Mussgnug & Partner**
**Patentanwälte mbB**
**Herzog-Wilhelm-Strasse 26**
**80331 München (DE)**

(56) Entgegenhaltungen:
**US-A1- 2004 046 224    US-A1- 2004 217 375**

• **RANBIR SINGH ET AL: "High-Power 4H-SiC JBS Rectifiers" IEEE TRANSACTIONS ON ELECTRON DEVICES, IEEE SERVICE CENTER, PISACATAWAY, NJ, US, Bd. 49, Nr. 11, November 2002 (2002-11), XP011072412 ISSN: 0018-9383**
• **WEIDE VAN DER D W: "DELTA-DOPED SCHOTTKY DIODE NONLINEAR TRANSMISSION LINES FOR 480-FS, 3.5-V TRANSIENTS" APPLIED PHYSICS LETTERS, AIP, AMERICAN INSTITUTE OF PHYSICS, MELVILLE, NY, US, Bd. 65, Nr. 7, 15. August 1994 (1994-08-15), Seiten 881-883, XP000464560 ISSN: 0003-6951**

**Beschreibung**

Die Erfindung betrifft ein integriertes vertikales JBS-SiC-Halbleiterbauelement.

Die vorliegende Erfindung sowie die ihr zugrunde liegende Problematik wird nachfolgend anhand einer JBS-Diodenstruktur erläutert, ohne jedoch die Erfindung auf diesen Bauelement-Typ zu beschränken. Vielmehr lässt sich die Erfindung auch bei anderen Halbleiterstrukturen, die gemischte Schottky-Strukturen und bipolare Strukturen aufweisen, erweitern, beispielsweise auf Sperrschicht-Transistoren.

Heutige Halbleiterbauelemente werden vorwiegend aus einem Halbleitermaterial wie Silizium oder auch aus Gallium-Arsenid (GaAs) und Gallium-Phosphit ($Ga_3P_4$) erzeugt, die allerdings eine geringe thermische, chemische und physikalische Stabilität aufweisen.

Siliziumcarbid (SiC) ist hingegen ein Halbleitermaterial, das insbesondere aufgrund seines Wurtzite- bzw. Zinkblendekristallgitters eine physikalisch hochstabile Kristallstruktur aufweist. Je nach Polytyp weisen SiC-Einkristalle einen großen energetischen Bandabstand von 2,2 eV bis 3,3 eV auf, wodurch sie thermisch und insbesondere mechanisch besonders stabil und widerstandsfähig gegen Strahlenschäden sind. Dies macht SiC sehr attraktiv für solche Halbleiterbauelemente, die extremen Temperaturen, Betriebs- und Umweltbedingungen ausgesetzt sind, wie sie beispielsweise in der Automobil- und Bahntechnik herrschen. Auf SiC basierende Halbleiterbauelemente sind in der Lage, in einem großen Spannungs- und Temperaturintervall, zum Beispiel bis zu 650 C bis 800° C, zu arbeiten, weisen sehr gute Schalt-Eigenschaften und geringe Verluste auf und lassen sich zudem bei sehr hohen Arbeitsfrequenzen betreiben. Im Vergleich zu Silizium weist SiC aufgrund der besseren Material-Eigenschaften ein stärkeres Durchbruchsfeld (bis zu 10-mal höher als bei Silizium), eine höhere Wärmeleitfähigkeit (mehr als 3-mal höher als bei Silizium) und eine größere Energiebandlücke (2,9 eV für 6H-SiC) auf. Als Halbleitermaterial kommt Siliziumcarbid (SiC) daher vor allem in solchen Leistungsbauelementen zum Einsatz die für sehr hohe Sperrspannungen (600 V bis einige kV) und hohe Betriebsspannungen ausgelegt sind. Zu nennen sind hier insbesondere Schottkydioden und PN-Leistungsdioden.

Die US 2004/0217375 A1 beschreibt eine SiC-Schottkydiode, die eine an einen Anodenkontakt angeschlossene Driftzone aufweist, wobei die Driftzone eine Abfolge von abwechselnd hoch dotierten und schwächer dotierten Halbleiterschichten des gleichen Leitungstyps aufweist.

Der Einsatz hoher Betriebsspannungen hat meist den Zweck, größere elektrische Leistungen (im Bereich von einigen Kilowatt) bei gleichem Strom umsetzen zu können. Um bei hoch sperrenden SiC-Dioden eine gegenüber herkömmlichen Anwendungen verbesserte Stoßstromfestigkeit zu realisieren, ist es vorteilhaft, einen sogenannten JBS-Diodentyp zu versenden. Dioden dieses Typs werden in der einschlägigen Literatur als JBS-Dioden (Junction-Barrier-Schottky-Dioden) oder auch als Sperrschicht-Schottkydioden bezeichnet (siehe beispielsweise RANBIR SINGH et al: "High-Power 4H-SiC JBS-Rectifiers"; IEEE Transactions on Electron Devices; Bd. 49; 11. November 2002; S. 2054 - 2063 und die US 2004/0046224 A1).

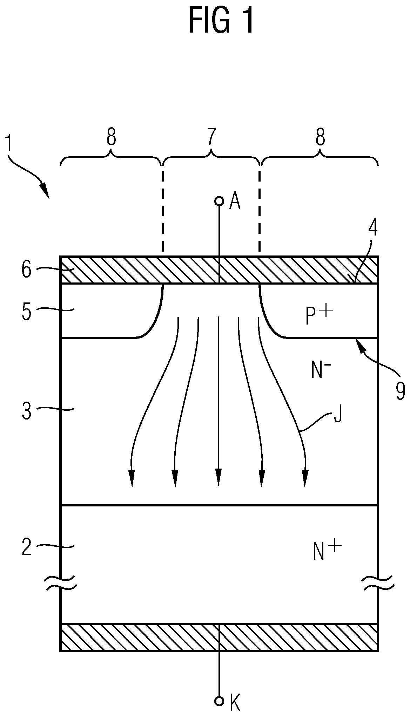

Fig. 1 zeigt anhand eines schematischen Teilschnittes den Aufbau einer JBS-Diode zur Erläuterung der allgemeinen Problematik. Die JBS-Diode 1 umfasst einen stark N-dotierten Halbleiterkörper 2, auf dem anodenseitig eine schwach N-dotierte Driftzone 3 aufgebracht ist. An einer anodenseitigen Oberfläche 4 sind mehrere stark P-dotierte Emitterzonen 5 in die Driftzone 3 eingebettet, die lateral voneinander beabstandet sind. Die Driftzone 3 tritt dabei zwischen benachbarte Emitterzonen 5 an die Oberfläche 4. Eine mit dem Anodenanschluss A verbundene Anodenmetallisierung 6 kontaktiert somit die an die Oberfläche 4 tretenden Bereiche der Driftzone 3 und der Emitterzonen 5.

Die JBS-Diode 1 ist somit durch eine Aufteilung der Anodeseite in Schottky-Bereiche 7, bei denen die Driftzone 3 die Oberfläche 4 und somit die Anodenmetallisierung 6 kontaktiert, und einen bipolaren Bereich 8, bei dem die Emitterzone 5 mit der Driftzone 3 einen PN-Übergang 9 ausbildet charakterisiert. Die Schottkybereiche 7 führen im Durchlassbetrieb den Strom J, während die bipolaren Bereiche 8 im Sperrbetrieb der Abschirmung der Metall-Halbleiter-Übergänge und somit der Schottky-Bereiche 8 dienen. Die Flächenaufteilung zwischen Schottky-Bereichen 7 und bipolaren Bereichen 8 ist innerhalb gewisser Grenzen für die spezifischen Anforderungen jeweils frei wählbar.

Problematisch an der JBS-Diodenstruktur, wie sie in Fig. 1 der Zeichnung dargestellt ist, ist die Stromdurchflutung der Driftzone 3 im Durchlassbetrieb. In Fig. 1 ist der Stromfluss J von Majoritätsladungsträgern im Durchlassbetrieb der JBS-Diode angedeutet. Der Strom 3 fließt hier über die Anodenmetallisierung 6 im Schottky-Bereich 7, die Driftzone 3 und den Halbleiterkörper 2. Aufgrund der unterschiedlichen Flächenaufteilung zwischen Schottky-Bereich 7 und bipolarem Bereich 8 wird im Durchlassbetrieb die die Sperrspannung aufnehmende Driftzone 3 nicht homogen von dem Strom J durchflossen. Diese Inhomogenität der Stromdurchflutung der Driftzone 3 im Durchlassbetrieb ergibt sich insbesondere aufgrund der bipolaren Bereiche 8, welche im Durchlassbetrieb bei Spannungen von weniger als 3 V im so genannten speicherladungsfreien Nennbetrieb keinerlei Strom führen. Diese bipolaren Bereiche 8 werden typischerweise so dimensioniert, dass sie nur bei auftretendem Stoßstrom den sich dadurch ergebenden Strom sicher führen können.

Die inhomogene Stromdurchflutung der Driftzone 3 im Durchlassbetrieb hat zur Folge, dass der Bahnwiderstand in der Driftzone 3 mit zunehmender Inhomogenität des Stromflusses 3 größer wird. Ein größerer Bahnwiderstand geht unmittelbar einher mit steigenden Verlusten verglichen mit einer Schottky-Diode mit ganzflächiger Schottky-Kontaktierung, die also ohne bipolare Bereiche 8 ausgebildet ist und bei der somit die Driftzone 3 im Durchlassbetrieb homogen von dem Stromfluss J durchflossen ist. Höhere Verluste gehen unmittelbar einher mit einer starken Erwärmung der JBS-Diode, was es allerdings in vielen Anwendungsfällen möglichst zu vermeiden gilt.

Das Ausmaß der Inhomogenität der Stromdurchflutung hängt im Wesentlichen von der Flächenaufteilung der bipolaren Bereiche zu den Schottky-Bereichen 7 ab. Durch eine Optimierung der Flächenaufteilung zwischen bipolaren Bereichen 8 und Schottky-Bereichen 7 lässt sich eine Optimierung der mit einer JBS-Diode 1 einhergehenden Sperrspannung, deren Sperrstrom und deren Spannungsabfall im Durchlassbetrieb bei hohen Stoßströmen realisieren. Allerdings stößt diese Optimierung sehr schnell an ihre Grenzen.

Vor diesem Hintergrund liegt der vorliegenden Erfindung die Aufgabe zugrunde, ein verbessertes JBS-SiC-Halbleiterbauelement bereit zu stellen, das insbesondere eine homogenere Stromdurchflutung im Durchlassbetrieb ermöglicht.

Erfindungsgemäß wird diese Aufgabe durch ein JBS-SiC-Halbleiterbauelement mit den Merkmalen des Patentanspruchs 1 gelöst.

Die der vorliegenden Erfindung zugrunde liegende Idee besteht darin, innerhalb der Driftzone eine zusätzliche Zwischenschicht anzuordnen, die bezogen auf die Anode unterhalb der bipolaren Bereiche und der Schottky-Bereiche angeordnet ist. Diese Zwischenschicht sollte typischerweise eine signifikant höhere Dotierungskonzentration als die sie umgebenden Bereiche der Driftzone, an die sie angrenzt, aufweisen. Wesentlich dabei ist, dass diese Zwischenschicht von den bipolaren Bereichen, das heißt von den Emitterzonen und zudem auch von den Schottky-Bereichen, das heißt von der ersten Oberfläche, beabstandet ist. Mittels der so in der Driftzone angeordneten Zwischenschicht lässt sich im Durchlassbetrieb des JBS-Halbleiterbauelementes der Stromfluss von Anode zu Kathode durch die relativ hoch dotierte Zwischenschicht lateral verteilen. Die Ladungsträger fließen anschließend von der Zwischenschicht mehr oder weniger vertikal und damit homogen verteilt in die darunter liegenden Bereiche der Driftzone hin zur Kathode des JBS-Halbleiterbauelementes.

Durch das erfindungsgemäße Einfügen der Zwischenschicht in die Driftzone wird also die Querleitfähigkeit im Durchlassbetrieb des JBS-Halbleiterbauelementes aufgrund der deutlich höheren Dotierungskonzentration dieser Zwischenschicht gegenüber den diese umgebenden Bereichen der Driftzone erhöht. Dadurch kommt es im Durchlassbetrieb zu einer sehr homogenen Durchflutung der Driftzonen, welche kathodenseitig unter der Zwischenschicht angeordnet sind. Durch die bessere Flächenausnutzung kann der spezifische Durchlasswiderstand bedingt durch die nun optimalere Stromaufteilung im kathodenseitigen Driftbereich signifikant reduziert werden, was unmittelbar auch zu geringeren Verlusten im Durchlassbetrieb führt. Dadurch können entweder die statischen Verluste weiter reduziert werden oder die für einen bestimmten Nennstrom notwendige Fläche des SiC-Halbleiterkörpers kann verringert werden. Ein geringerer Bedarf des SiC-Halbleiterkörpers zur Bereitstellung derselben Funktionalität bringt Kostenvorteile mit sich, insbesondere da es sich bei SiC um ein im Vergleich zu herkömmlichen Silizium außerordentlich teures Halbleitermaterial handelt.

Auf der anderen Seite werden die Sperreigenschaften des für hohe Sperrspannungen ausgelegten JBS-Halbleiterbauelementes vorteilhafterweise beibehalten, da in dem Driftbereich oberhalb der eingefügten Zwischenschicht, das heißt in dem anodenseitigen Driftzonenbereich, die Funktion der sich durch die Emitterzonen ergebenden Raumladungszone, welche die Schottky-Bereiche im Sperrbetrieb abschirmt, gewährleistet ist.

Vorteilhafte Ausgestaltungen und Weiterbildungen der Erfindung ergeben sich aus den weiteren Unteransprüchen sowie aus der Beschreibung in Zusammenschau mit der Zeichnung.

In einer besonders bevorzugten Ausgestaltung unterteilt die Zwischenschicht somit die Driftzone in zumindest eine anodenseitige Driftzonenschicht und zumindest eine kathodenseitige Driftzonenschicht, wodurch diese voneinander getrennt vorliegen.

In einer besonders vorteilhaften Ausgestaltung ist die Zwischenschicht in einem minimalen Abstand zur ersten Oberfläche innerhalb der Driftzone derart angeordnet, dass im Durchlassbetrieb des Halbleiterbauelementes ein im Wesentlichen vertikaler Stromfluss von der Zwischenschicht zum Halbleiterkörper hin, und somit innerhalb der kathodenseitigen Driftzonenschicht, vorhanden ist. Der minimale Abstand ist ferner so dimensioniert, dass im Sperrbetrieb die Zwischenschicht dennoch außerhalb einer sich von einem PN-Übergang zwischen den Emitterzonen und der Driftzone ausdehnenden Raumladungszone liegt.

Insbesondere gilt für den minimalen Abstand d1 zwischen der ersten Oberfläche und der Zwischenschicht folgender Zusammenhang:

$$d1 = \frac{5700}{\sqrt{Nd4}} + d2\,;$$

Nd4 bezeichnet dabei die Dotierungskonzentration der Emitterzone und d2 bezeichnet die vertikale Tiefe der Emitterzone bezogen auf die erste Oberfläche, an die die Emitterzone angrenzt.

In einer sehr vorteilhaften Ausgestaltung ist eine Pufferschicht des ersten Leitfähigkeitstyps vorgesehen. Diese Pufferschicht ist lateral durchgehend zwischen der Driftzone und dem Halbleiterkörper angeordnet. Vorzugsweise trennt diese Pufferschicht die Driftzone und den Halbleiterkörper vollständig voneinander. Die Pufferschicht weist eine gegenüber der angrenzenden Driftzone höhere Dotierungskonzentration und eine gegenüber dem angrenzenden Halbleiterkörper niedrigere Dotierungskonzentration auf. Das Vorsehen einer Pufferschicht ist dann vorteilhaft, wenn das Halbleiterbauelement mit einem so genannten Punch-Through-(PT-)Design ausgebildet sein soll, um auf diese Weise eine sich vom PN-Übergang ausbreitende Raumladungszone von dem stark dotierten Halbleiterkörper abzuhalten. Im Falle eines so genannten Non-Punch-Through-(NPT-)Designs des Halbleiterbauelementes ist eine solche Pufferschicht nicht unbedingt erforderlich, jedoch nicht notwendigerweise nachteilig. Solche PT- und NPT-Designs sowie deren Funktionen sind bei IGBT Halbleiterbauelementen (IGBT = Insulated Gate Bipolar Transistor) allgemein bekannt, sodass hier nicht näher auf diese Strukturen sowie deren Funktion eingegangen wird.

Typischerweise weist die Zwischenschicht eine gegenüber dem Halbleiterkörper niedrigere Dotierungskonzentrationen auf.

In einer typischen Ausgestaltung weist die anodenseitige Driftzonenschicht, die also an den PN-Übergang bzw. die erste Oberfläche angrenzt, eine geringere Dotierungskonzentration als die kathodenseitige Driftzonenschicht auf. Typischerweise, jedoch nicht notwendigerweise, weist die kathodenseitige Driftzonenschicht eine im Bereich von 5% bis 40%, insbesondere im Bereich von 10% bis 20%, höhere Dotierungskonzentrationen als die darüber liegende anodenseitige Driftzonenschicht auf. Denkbar, sofern dies prozesstechnisch machbar ist, wäre allerdings auch, wenn beide Driftzonenschichten innerhalb der Driftzone dieselbe Dotierungskonzentration aufweisen. Technologisch ist dies allerdings sehr schwer realisierbar, da im Falle einer auf die zweite Driftzonenschicht epiktaktisch aufgewachsenen Zwischenschicht bei sonst gleich eingestellten Prozessparametern die darauf aufgebrachte erste Driftzonenschicht üblicherweise eine geringfügig andere Dotierungskonzentration aufweist.

In einer typischen Ausgestaltung weisen die Emitterzonen eine sehr hohe Dotierungskonzentration im Bereich zwischen $1*10^{18}$ cm$^{-3}$ und $1*10^{22}$ cm$^{-3}$ auf. Vorzugsweise liegt die Dotierung der Zonen zwischen $1*1^{19}$ cm$^{-3}$ und $1*10^{21}$ cm$^{-3}$. Die Verwendung einer Emitterzone mit sehr hoher Dotierungskonzentration weist zum einen den Vorteil auf, dass dadurch eine hohe Emittereffizienz realisierbar ist. Zum anderen kann auf diese Weise eine bessere elektrische Kontaktierung einer Anodenmetallisierung gewährleistet werden, was bei SiC im Unterschied zu Silizium immer Schwierigkeiten in sich birgt.

In einer bevorzugten Ausgestaltung weist die durchgehende Zwischenschicht eine Dotierungskonzentration im Bereich zwischen $1*10^{17}$ cm$^{-3}$ und $1*10^{19}$ cm$^{-3}$ auf. Vorzugsweise liegt die Dotierungskonzentration dieser Zwischenschicht im Bereich $5*10^{17}$ cm$^{-3}$ und $5*10^{18}$ cm$^{-3}$. Eine durchgehende Zwischenschicht weist somit eine signifikant höhere Dotierungskonzentration als die sie umgebenden Driftzonenschichten auf. Im Falle einer durchgehenden Zwischenschicht ist deren Dotierungskonzentration typischerweise um ein bis drei, vorzugsweise eine um ein bis zwei Größenordnungen größer als die der Driftzone. Unter einer Größenordnung ist eine 10er-Potenz also der Faktor 10 zu verstehen, unter zwei und drei Größenordnungen ist somit $10^2 = 100$ bzw. $10^3 = 1000$ zu verstehen.

In einer typischen Ausgestaltung weist der Halbleiterkörper eine rückseitige zweite Oberfläche auf, die großflächig mit einer Kathodenmetallisierung elektrisch leitend, das heißt ohmsch, kontaktiert ist. Ferner ist die vorderseitige erste Oberfläche des Halbleiterbauelementes großflächig mit einer Anodenmetallisierung elektrisch leitend kontaktiert, welche sowohl die an die vorderseitige Oberfläche angrenzenden Bereiche der Emitterzone wie auch die an die vorderseitige Oberfläche angrenzenden Bereiche der Driftzone kontaktiert. Als Kontakte eignen sich hier insbesondere Nickelverbindungen, wie beispielsweise Nickel-Aluminium Legierungen. Denkbar wären allerdings auch andere Legierungen, wie beispielsweise auf der Basis von Wolfram, Titan, Tantal, Silizide und dergleichen.

In einer besonders bevorzugten Ausgestaltung ist das Halbleiterbauelement als so genannte JBS-Diode und insbesondere als JBS-Leistungsdiode ausgebildet. Die erfindungsgemäße JBS-Diode vereint somit in sich die Vorteile einer herkömmlichen Schottky-Diode, was die relativ hohe Homogenität der Stromdurchflutung im Driftbereich angeht, und die Eigenschaften einer herkömmlichen JBS-Diode, was die hohe Sperrspannungsfestigkeit angeht.

Weitere besonders bevorzugte Anwendungsbeispiele für das erfindungsgemäße Halbleiterbauelement sind Sperrschicht-Transistoren, beispielsweise ein vertikaler JFET. Alternativ sind auch Metall-Isolator-Halbleiter-Feldeffekttransistoren, so genannte MISFETs, denkbar.

Die Erfindung wird nachfolgend anhand der in den schematischen Figuren der Zeichnung angegebenen Ausführungsbeispiele näher erläutert. Es zeigt dabei:

Fig. 1    einen Teilschnitt einer im Durchlassbetrieb betriebenen JBS-SiC-Diode zur Erläuterung der allgemeinen Problematik;

Fig. 2    anhand eines Teilschnitts ein erstes Ausführungsbeispiel einer erfindungsgemäßen, im Durchlassbetrieb betriebenen JBS-SiC-Diode;

Fig. 2a    die Dotierungsverhältnisse der verschiedenen Gebiete und Schichten der erfindungsgemäßen JBS-SiC-Diode aus Fig. 2;

Fig. 2b    anhand eines Teilschnitts die im Sperrbetrieb betriebenen JBS-SiC-Diode aus Fig. 2;

Fig. 3    anhand eines Teilschnitts ein zweites Ausführungsbeispiel einer erfindungsgemäßen, im Durchlassbetrieb betriebenen JBS-SiC-Diode.

In den Figuren der Zeichnung sind gleiche und funktionsgleiche Elemente, Merkmale und Signale - sofern nicht Anderes angegeben ist - mit denselben Bezugszeichen versehen worden.

In der nachfolgenden Figurenbeschreibung und in der gesamten Patentanmeldung bezieht sich der Begriff "SiC" auf alle wichtigen Kristall-Polytypen von Siliziumcarbid und dabei insbesondere auf 6H-, 4H-, 2H-, 3C- und 15R-Polytypen. Bei SiC als Halbleitermaterial entspricht die eingebrachte Dotierung sehr häufig nicht der für den Stromfluss vorgesehenen, so genannten elektrisch aktiven Dotierung. Unter Dotierung ist hier stets die in den jeweiligen Halbleiterkörper eingebrachte Dotierung zu verstehen. Nachfolgend sei auch stets eine JBS-Diode auf SiC-Basis zu verstehen, auch wenn lediglich von JBS-Diode die Rede ist.

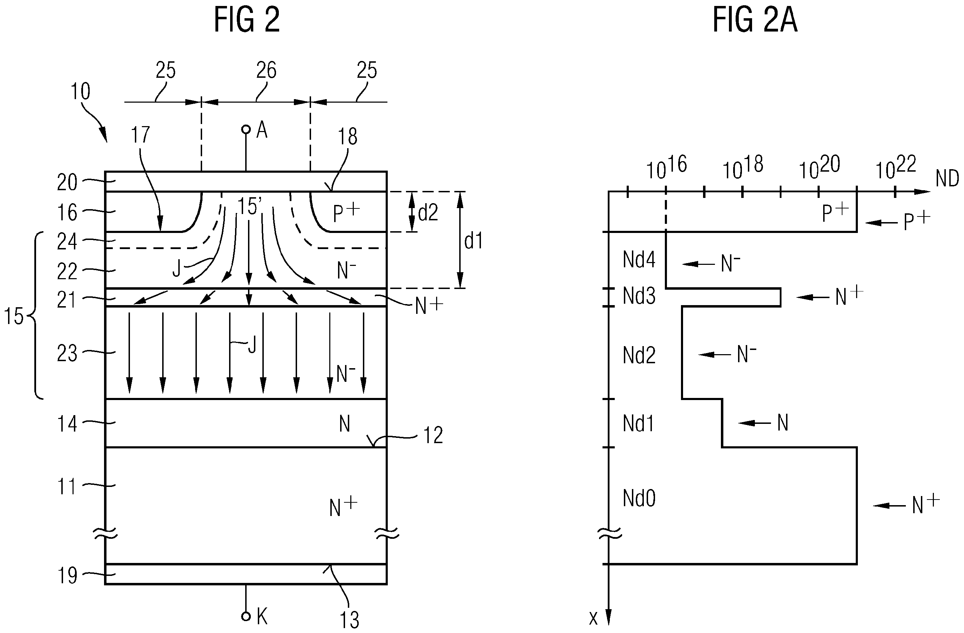

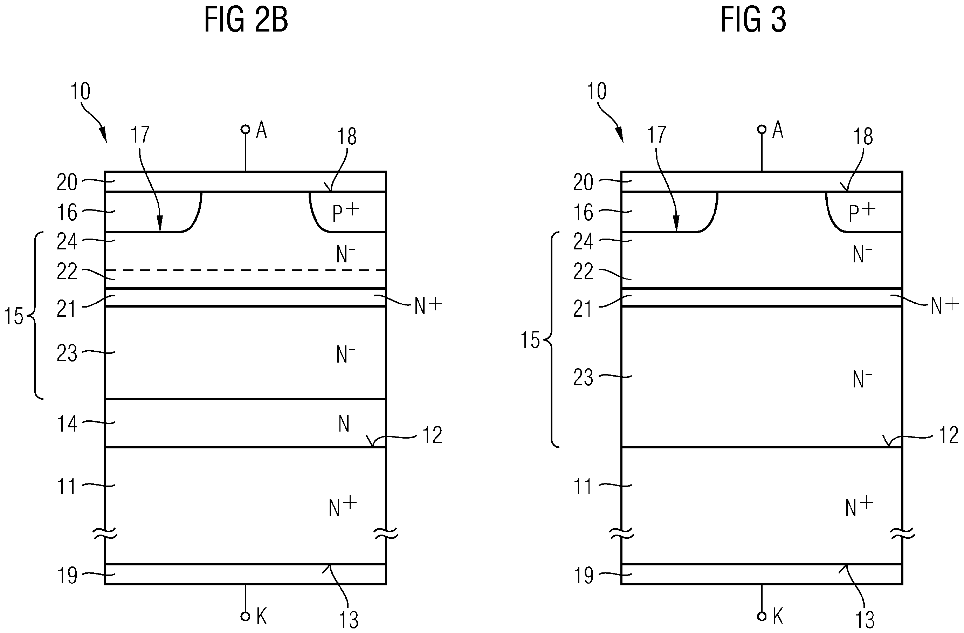

Fig. 2 zeigt anhand eines Teilschnitts ein erstes Ausführungsbeispiel einer erfindungsgemäßen, im Durchlassbetrieb betriebenen JBS-Diode. Fig. 2a zeigt die Dotierungsverhältnisse der verschiedenen Gebiete und Schichten der JBS-Diode aus Fig. 2, wobei auf der Abszisse die Tiefe x der JBS-Diode von der anodenseitigen Vorderseite her in linearer Form und auf der Ordinate die Dotierungskonzentration ND der einzelnen Schichten in logarithmischer Form in der Einheit cm$^{-3}$ dargestellt ist. Fig. 2b zeigt anhand eines Teilschnitts die im Sperrbetrieb betriebene JBS-Diode aus Fig. 2.

Die mit Bezugszeichen 10 bezeichnete JBS-Diode enthält einen SiC-Halbleiterkörper 11 bzw. ein SiC-Substrat. Der SiC-Halbleiterkörper 11, der zum Beispiel Bestandteil eines SiC-Wafers ist, weist eine starke N-Dotierung auf. Der SiC-Halbleiterkörper 11 weist eine vorderseitige Oberfläche 12 und eine rückseitige Oberfläche 13 auf.

Auf der vorderseitigen Oberfläche 12 des Halbleiterkörpers 11 ist eine Pufferschicht 14 aufgebracht. Die Pufferschicht 14 weist eine geringere Dotierungskonzentration als der Halbleiterkörper 11 auf. Die Pufferschicht 14 gewährleistet ein PT-Design der JBS-Diode 10 und soll unter anderem verhindern, dass eine Raumladungszone von einem PN-Übergang in den Halbleiterkörper 11 hinein reicht.

Auf der Pufferschicht 14 ist eine schwach N-dotierte Driftzone 15 aufgebracht. Die Dotierungskonzentration der Driftzone 15 ist typischerweise mindestens um ein bis zwei Größenordnungen geringer als die der Pufferschicht 14.

An der Seite einer vorderseitigen Oberfläche 18 der JBS-Diode 10 sind stark P-dotierte Emitterzonen 16 in die Driftzone 15 eingebettet. Eine Grenzfläche zwischen der Driftzone 15 und der Emitterzone 16 definiert einen PN-Übergang 17 der JBS-Diode 10, von der sich im Sperrbetrieb (siehe Fig. 2b) eine Raumladungszone 24 in die Driftzone 15 einerseits und die Emitterzone 16 andererseits ausbreiten kann. Die Emitterzone 16 grenzen in einem bipolaren Bereich 25 der JBS-Diode 10 an die vorderseitige Oberfläche 18 an. Im vorliegenden Beispiel sind die Emitterzonen 16 lateral voneinander beabstandet, wobei die Driftzone 15 in dem Driftzonenbereich 15' zwischen zwei benachbarten bzw. voneinander beabstandeten Emitterzonen 16 an die vorderseitige Oberfläche 18 angrenzt. Dieser Bereich definiert einen so genannten Schottky-Bereich 26 der JBS-Diode 10.

An dieser Stelle sei angemerkt, dass die Emitterzonen 16 nicht notwendigerweise voneinander beabstandet sein müssen. Im Layout der Draufsicht können diese vielmehr eine beliebige Struktur aufweisen, beispielsweise streifenförmig, mäanderförmig, dreieckig, quadratisch, rund etc. oder auch als durchgehende, mit entsprechenden runden, eckigen, etc. Löchern versehene Struktur. Wesentlich dabei ist lediglich, dass die Emitterzonen 16 im Sperrbetrieb geeignet sind, die Raumladungszone 24 so auf die Schottky-Bereiche 26 auszudehnen, dass dort ein Stromfluss abgeschnürt ist.

Die so ausgebildete SiC-JBS-Diode weist eine vorderseitige Oberfläche 18, die die Oberfläche der Emitterzonen 16 (bipolarer Bereiche 25) sowie der im Bereich der Schottky-Bereiche 26 tretende Driftzone 15' bildet, auf. Ferner ist eine rückseitige Oberfläche 13 vorgesehen, die identisch ist mit der rückseitigen Oberfläche 13 des Halbleiterkörpers 11. Auf der rückseitigen Oberfläche 13 ist großflächig eine Kathodenmetallisierung 19 aufgebracht, die mit einem Kathodenanschluss K verbunden ist. Auf der vorderseitigen Oberfläche 18 ist eine großflächige Anodenmetallisierung 20 aufgebracht, die mit einem Anodenanschluss A verbunden ist. Abhängig von dem Dotierungstyp der entsprechend angrenzenden Halbleiterschicht (also N oder P) sowie deren Dotierungskonzentrationen werden dabei jeweils geeignete Materialien herangezogen, wobei sich Nickellegierungen und insbesondere Nickel-Aluminium-Legierungen (Ni$_x$Al$_y$) hier als besonders vorteilhaft heraus gestellt haben. Ebenfalls besonders vorteilhaft ist es, wenn die unter der jeweiligen Metallisierung 19, 20 liegenden Halbleitergebiete 11, 15', 16 eine möglichst hohe Dotierungskonzentration für die Gewährleistung eines ohmschen Kontaktes mit möglichst geringem Kontaktwiderstand aufweist.

Erfindungsgemäß ist nun innerhalb der Driftzone 15 eine Zwischenschicht 21 angeordnet. Die Zwischenschicht 21 ist stark N-dotiert und weist eine zumindest um ein bis zwei Größenordnungen höher Dotierungskonzentration als die sie umgebenden Bereiche der Driftzone 15 auf. In Fig. 2 ist die Zwischenschicht 21 als eine lateral durch die gesamte Driftzone 15 durchgehende Schicht ausgebildet, sodass sie die Driftzone 15 in eine erste anodenseitige Driftzonenschicht 22 und eine zweite katodenseitige Driftzonenschicht 23 teilt, die voneinander durch die Zwischenschicht 21 getrennt sind. Die beiden Driftzonenschichten 22, 23 weisen im vorliegenden Ausführungsbeispiel etwa eine ähnliche Dotierungskonzentration auf, wobei die kathodenseitige Driftzonenschicht 23 typischerweise eine im Bereich von 5 % bis 40 % höhere Dotierungskonzentration als die anodenseitige Driftzonenschicht 22 aufweist (siehe Fig. 2a).

Die Zwischenschicht 21 ist ferner von der Oberfläche 18 in einem Abstand d1 angeordnet. Der Abstand d1 sollte dabei so ausgelegt sein, dass im Durchlassbetrieb des Halbleiterbauelementes (siehe Fig. 2) eine möglichst vertikale Stromflussrichtung J von der Zwischenschicht 21 zum Halbleiterkörper 11 hin, und somit innerhalb der kathodenseitigen Driftzonenschicht 23, vorhanden ist. Andererseits muss der minimale Abstand d1 auch so gewählt werden, dass im Sperrbetrieb (siehe Fig. 2b) keine Beeinträchtigung der zur Abschirmung des elektrischen Feldes notwendigen Ausdehnung der Raumladungszonen zwischen den p+-Gebieten erfolgt. Die Zwischenschicht 21 liegt also außerhalb der hierfür charakteristischen Raumladungszone 24, so dass keine Reduzierung der Sperrfähigkeit bei der Betriebsspannung (z. B. = Zwischenkreisspannung) auftritt. Der minimale Abstand d1 zur ersten Oberfläche 18 ist daher abhängig von der Dotierungskonzentration der Emitterzonen 16 und der vertikalen Tiefe d2 der Emitterzone bezogen auf die erste Oberfläche 18 vorzugsweise wie folgt ausgelegt:

$$d1 = \frac{5700}{\sqrt{Nd4}} + d2 \; ;$$

Die Dicke der Zwischenschicht ergibt sich aus einer Optimierung des vertikalen elektrischen Feldverlaufes durch Lösen der Poissongleichung. D.h. die Flächenladung (=Nd3*d3) in der Zwischenschicht 21 muss deutlich unter der dem Feld entsprechenden kritischen Ladung liegen, so dass die Feldausdehnung in die kathodenseitige Driftzonenschicht 23 nicht vollständig abgeschirmt wird. Als Beispiel sei hier eine Dotierung Nd3 der Zwischenschicht 21 von Nd3 = $1*10^{18}$/cm$^3$ und d3 = 100 nm genannt.

Für die Herstellung der JBS-Diode 10 werden die Pufferschicht 14, die kathodenseitige Driftzonenschicht 23, die Zwischenschicht 21 und die anodenseitige Driftzonenschicht 22 nacheinander auf den Halbleiterkörper 11 epiktaktisch aufgewachsen. Die Dotierung dieser Schichten 14, 21-23 erfolgt während der Epitaxie z. B. durch Beimischung der entsprechend gewünschten Dotierstoffe in der entsprechend gewünschten Dosis. Als Dotierstoffe für die N-Dotierung der Schichten 14, 21 - 23 eignet sich vorzugsweise Stickstoff oder Phosphor. Alternativ können diese einzelnen Schichten 14, 21 - 23 auch durch Ionenimplantation dotiert werden. Allerdings muss nach der Ionenimplantation eine Hochtemperaturbehandlung zum Ausheilen von Kristallschäden und zum elektrischen Aktivieren der eingebrachten Dotierstoffatome erfolgen. Ein besonderer Vorteil ergibt sich, wenn die Hochtemperaturbehandlung bereits während der Ionenimplantation durchgeführt wird, beispielsweise unter Anwendung der Hochtemperatur-Ionenimplantation.

Die Emitterzonen 16 werden vorzugsweise durch Ionenimplantation in die Driftzone 15 eingebracht.

Fig. 3 zeigt einen Teilschnitt eines zweiten Ausführungsbeispiels einer erfindungsgemäßen SiC-JBS-Diode. Im Unterschied zu dem Ausführungsbeispiel in Fig. 2 enthält die JBS-Diode 10 hier keine Pufferschicht 14, sodass hier ein NPT-Design implementiert ist. Hier wird die Driftzone 15 also direkt auf den Halbleiterkörper 11 aufgebracht.

Obgleich die vorliegende Erfindung vorstehend anhand bevorzugter Ausführungsbeispiele beschrieben wurde, sei sie nicht darauf beschränkt, sondern lässt sich auf vielfältige Art und Weise modifizieren.

Es versteht sich von selbst, dass durch Austausch der Leitfähigkeitstypen N gegen P und umgekehrt sowie durch Variation der Dotierungskonzentrationen, der Schichtdicken und Abstände eine beliebige Vielzahl modifizierter JBS-Halbleiterbauelemente bereitgestellt werden könnte, ohne vom Wesen der vorliegenden Erfindung abzuweichen. Auch die angegebenen Herstellungsverfahren wurden lediglich beispielhaft aufgeführt, ohne die Erfindung jedoch dahingehend einzuschränken. Auch die verwendeten Materialien (mit Ausnahme von SiC), insbesondere die der Metallisierungen und Dotierstoffe, seien lediglich beispielhaft zu verstehen und können auch durch geeignete andere Materialien ersetzt werden.

**Patentansprüche**

1. Integriertes vertikales JBS-SiC-Halbleiterbauelement (10), aufweisend:

   a) einen hochdotierten SiC-Halbleiterkörper (11) eines ersten Leitfähigkeitstyps (n oder p), wobei eine kathodenseitige Oberfläche (13) des SiC -Halbleiterkörpers (11) mit einem ersten flächigen elektrischen Kontakt (19) versehen ist;
   b) einer auf dem SiC-Halbleiterkörper (11) angeordneten, niedrig dotierten Driftzone (15) des ersten Leitfähigkeitstyps (n oder p), wobei eine anodenseitige Oberfläche (18) der Driftzone (15) mit einem zweiten flächigen elektrischen Kontakt (20) versehen ist;
   c) mindestens eine in die Driftzone (15) eingebettete Emitterzone (16) eines zweiten Leitfähigkteitstyps (p oder n), wobei die in der Driftzone (15) einen pn-Übergang (17) bildende Emitterzone (16) an die anodenseitige Oberfläche (18) der Driftzone (15) angrenzt und von dem zweiten flächigen elektrischen Kontakt (20) kontaktiert wird;
   d) eine in lateraler Richtung durch die gesamte Driftzone durchgehende, die Driftzone (15) in eine anodenseitige Driftzonenschicht (22) und in eine kathodenseitige Driftzonenschicht (23) teilende Zwischenschicht (21) des ersten Leitfähigkeitstyps (n oder p), wobei die eine höhere Dotierungskonzentration als die Driftzone (15) aufweisende Zwischenschicht (21) von der mindestens einen Emitterzone (16) beabstandet ist.

2. Halbleiterbauelement nach Patentanspruch 1, **dadurch gekennzeichnet, dass** die Zwischenschicht (21) in einem minimalen vertikalen Abstand d1 von der anodenseitigen Oberfläche (18) der Driftzone (15) angeordnet ist, wobei der minimale vertikale Abstand d1 Bedingung

$$d1 = \frac{5700}{\sqrt{Nd4}} + d2$$

genügt und die Größe Nd4 die Dotierungskonzentration der Emitterzone (16) und die Größe d2 die vertikale Dicke der Emitterzone (16) bezeichnen.

3. Halbleiterbauelement nach Patentanspruch 1 oder 2,
**dadurch gekennzeichnet, dass** zumindest eine Pufferschicht (14) des ersten Leitfähigkeitstyps (n oder p) lateral zwischen der kathodenseitigen Driftzonenschicht (23) und dem Halbleiterkörper (11) angeordnet ist, wobei die Pufferschicht (14) eine gegenüber der kathodenseitigen Driftzonenschicht (23) höhere Dotierungskonzentration und eine gegenüber dem Halbleiterkörper (11) niedrigere Dotierungskonzentration aufweist.

4. Halbleiterbauelement nach wenigstens einem der Patentansprüche 1 bis 3,
**dadurch gekennzeichnet, dass** die Zwischenschicht (21) eine gegenüber dem Halbleiterkörper (11) niedrigere Dotierungskonzentration aufweist.

5. Halbleiterbauelement nach wenigstens einem der Patentansprüche 1 bis 4,
**dadurch gekennzeichnet, dass** die anodenseitige Driftzonenschicht (22) eine niedrigere Dotierungskonzentration aufweist als die kathodenseitige Driftzonenschicht (23).

6. Halbleiterbauelement nach wenigstens einem der Patentansprüche 1 bis 5,
**dadurch gekennzeichnet, dass** die Emitterzone (16) eine im Bereich zwischen $1 \times 10^{18}$ cm$^{-3}$ und $1 \times 10^{22}$ cm$^{-3}$ liegende, insbesondere eine im Bereich zwischen $1 \times 10^{19}$ cm$^{-3}$ und $1 \times 10^{21}$ cm$^{-3}$ liegende Dotierungskonzentration aufweist.

7. Halbleiterbauelement nach wenigstens einem der Patentansprüche 1 bis 6,
**dadurch gekennzeichnet, dass** die Zwischenschicht (21) eine im Bereich zwischen $1 \times 10^{17}$ cm$^{-3}$ und $1 \times 10^{20}$ cm$^{-3}$, insbesondere eine im Bereich

zwischen $1 \times 10^{17}$ cm$^{-3}$ und $5 \times 10^{18}$ cm$^{-3}$ liegende Dotierungskonzentration aufweist.

8. Halbleiterbauelement nach wenigstens einem der Patentansprüche 1 bis 7,
**dadurch gekennzeichnet, dass** die Zwischenschicht (21) eine um eine bis drei, vorzugsweise eine um eine bis zwei Größenordnungen höhere Dotierungskonzentration aufweist als die kathodenseitige und die anodenseitige Driftzonenschicht (22, 23).

9. Halbleiterbauelement nach wenigstens einem der Patentansprüche 1 bis 8,
**dadurch gekennzeichnet, dass** die kathodenseitige Oberfläche (13) des Halbleiterkörpers (11) mit einer ersten großflächigen Metallisierung (19) elektrisch leitend kontaktiert ist und dass die anodenseitige Oberfläche (18) der Driftzone (15) mit einer zweiten großflächigen Metallisierung (20) elektrisch leitend kontaktiert ist.

10. Halbleiterbauelement nach wenigstens einem der Patentansprüche 1 bis 9,
**dadurch gekennzeichnet, dass** das Halbleiterbauelement (10) als JBS-Diode (10), als Sperrschichttransistor oder als MISFET-Transistor ausgebildet ist.

**Claims**

1. Integrated vertical JBS-SiC semiconductor component (10), comprising:

   a) a highly doped SiC semiconductor body (11) of a first conductivity type (n or p), wherein a cathodal surface (13) of the SiC semiconductor body (11) is provided with a first planar electrical contact (19);
   b) a lightly doped drift zone (15) of the first conductivity type (n or p) arranged on the SiC semiconductor body (11), wherein an anodal surface (18) of the drift zone (15) is provided with a second planar electrical contact (20);
   c) at least one emitter zone (16) of a second conductivity type (p or n) embedded in the drift zone (15), wherein the emitter zone (16) forming a pn junction (17) in the drift zone (15) adjoins the anodal surface (18) of the drift zone (15) and is contacted by the second planar electrical contact (20);
   d) an intermediate layer (21) of the first conductivity type (n or p), which passes through the entire drift zone in a lateral direction and divides the drift zone (15) into an anodal drift zone layer (22) and into a cathodal drift zone layer (23), wherein the intermediate layer (21), having a higher doping concentration than the drift zone (15), is spaced apart from the at least one emitter zone (16).

2. Semiconductor component according to Patent Claim 1, **characterized in that** the intermediate layer (21) is arranged at a minimum vertical distance d1 from the anodal surface (18) of the drift zone (15), wherein the minimal vertical distance d1 meets the condition

$$d1 = \frac{5700}{\sqrt[4]{Nd4}} + d2 \; ;$$

and the variable Nd4 denotes the doping concentration of the emitter zone (16) and the variable d2 denotes the vertical thickness of the emitter zone (16).

3. Semiconductor component according to Patent Claim 1 or 2,
**characterized in that** at least one buffer layer (14) of the first conductivity type (n or p) is arranged laterally between the cathodal drift zone layer (23) and the semiconductor body (11), wherein the buffer layer (14) has a higher doping concentration than the cathodal drift zone layer (23) and a lower doping concentration than the semiconductor body (11).

4. Semiconductor component according to at least one of Patent Claims 1 to 3,
**characterized in that** the intermediate layer (21) has a lower doping concentration than the semiconductor body (11).

5. Semiconductor component according to at least one of Patent Claims 1 to 4,
**characterized in that** the anodal drift zone layer (22) has a lower doping concentration than the cathodal drift zone layer (23).

6. Semiconductor component according to at least one of Patent Claims 1 to 5,
**characterized in that** the emitter zone (16) has a doping concentration in the range of between $1 \times 10^{18}$ cm$^{-3}$ and $1 \times 10^{22}$ cm$^{-3}$, in particular a doping concentration in the range of between $1 \times 10^{19}$ cm$^{-3}$ and $1 \times 10^{21}$ cm$^{-3}$.

7. Semiconductor component according to at least one of Patent Claims 1 to 6,
**characterized in that** the intermediate layer (21) has a doping concentration in the range of between $1 \times 10^{17}$ cm$^{-3}$ and $1 \times 10^{20}$ cm$^{-3}$, in particular a doping concentration in the range of between $1 \times 10^{17}$ cm$^{-3}$ and $5 \times 10^{18}$ cm$^{-3}$.

8. Semiconductor component according to at least one of Patent Claims 1 to 7,
**characterized in that** the intermediate layer (21) has a doping concentration which is higher than that of the cathodal and anodal drift zone layers (22, 23) by one to three orders of magnitude, preferably by one to two orders of magnitude.

9. Semiconductor component according to at least one of Patent Claims 1 to 8,
**characterized in that** the cathodal surface (13) of the semiconductor body (11) is electrically conductively contacted with a first large-area metallization (19), and **in that** the anodal surface (18) of the drift zone (15) is electrically conductively contacted with a second large-area metallization (20).

10. Semiconductor component according to at least one of Patent Claims 1 to 9,
**characterized in that** the semiconductor component (10) is embodied as a JBS diode (10), as a junction transistor or as a MISFET transistor.

**Revendications**

1. Composant (10) à semiconducteur JBS-SiC, intégré vertical, comportant:

a) un corps (11) semiconducteur SiC très dopé d'un premier type (n ou p) de conductivité, une surface (13), du côté de la cathode, du corps (11) semiconducteur SiC, étant pourvue d'un premier contact (19) électrique plat,
b) une zone (15) de drift du premier type (n ou p) de conductivité, disposée sur le corps (11) semiconducteur SiC et peu dopée, une surface (18) du côté de l'anode, de la zone (15) de drift étant pourvue d'un deuxième contact (20) électrique plat,
c) au moins une zone (16) d'émetteur d'une deuxième type (p ou n) de conductivité, incorporée dans la zone (15) de drift, la zone (16) d'émetteur formant une jonction pn (17) dans la zone (15) de drift, étant voisine de la surface (18), du côté de l'anode, de la zone (15) de drift et étant contactée par le deuxième contact (20) électrique plat,
d) une couche (21) intermédiaire du premier type (n ou p) de conductivité traversant toute la zone de drift et séparant la zone (15) de drift en une couche (22) de zone de drift, du côté de l'anode et en une couche (23) de zone de drift, du côté de la cathode, la zone (21) intermédiaire, ayant une concentration de dopage plus grande que la zone (15) de drift, étant à distance de la au moins une zone (16) d'émetteur.

2. Composant à semiconducteur suivant la revendication 1, **caractérisé en ce que** la couche (21) intermédiaire est à une distance d1 verticale minimum de la surface (18), du côté de l'anod,e de la zone (15) de drift, la distance d1 verticale minimum satisfaisant la condition

$$d1 = \frac{5700}{\sqrt{Nd4}} + d2$$

et la grandeur Nd4 désignant en la concentration de dopage de la zone (16)d'émetteur et la grandeur d2 l'épaisseur verticale de la zone (16) d'émetteur.

3. Composant à semiconducteur suivant la revendication 1 ou 2,
**caractérisé en ce qu'**au moins une couche (14) tampon du premier type (n ou p) de conductivité est disposée latéralement entre la couche (23) de zone de drift, du côté de la cathode, et le corps (11) semiconducteur, la couche (14) tampon ayant une concentration de dopage plus grande que la couche (23) de zone de drift, du côté de la cathode, et une concentration de dopage plus petite que le corps (11) semiconducteur.

4. Composant à semiconducteur suivant au moins l'une des revendications 1 à 3,
caractrisé en ce que la couche (21) intermédiaire a une concentration de dopage plus petite que le corps (11) semiconducteur.

5. Composant à semiconducteur suivant au moins l'une des revendications 1 à 4,
**caractérisé en ce que** la couche (22) de zone de drift, du côté de l'anode, a une concentration de dopage plus petite que la couche (23) de zone de drift, du côté de la cathode.

6. Composant à semiconducteur suivant au moins l'une des revendications 1 à 5,
**caractérisé en ce que** la zone (16) d'émetteur a une concentration de dopage dans la plage comprise entre $1 \times 10^{18}$ cm$^{-3}$ et $1 \times 10^{22}$ cm$^{-3}$, notamment dans la plage comprise entre $1 \times 10^{19}$ cm$^{-3}$ et $1 \times 10^{21}$ cm$^{-3}$.

7. Composant à semiconducteur suivant au moins l'une des revendications 1 à 6,
**caractérisé en ce que** la couche (21) intermédiaire a une concentration de dopage dans la plage comprise entre $1 \times 10^{17}$ cm$^{-3}$ et $1 \times 10^{20}$ cm$^{-3}$, notamment dans la plage comprise entre $1 \times 10^{17}$ cm$^{-3}$ et $5 \times 10^{18}$ cm$^{-3}$.

8. Composant à semiconducteur suivant au moins l'une des revendications 1 à 7,
**caractérisé en ce que** la couche (21) intermédiaire a une concentration de dopage plus grande de un à trois, de préférence d'un à deux, ordres de grandeur que la couche (22, 23) de zone de drift, du côté de la cathode et du côté de l'anode.

9. Composant à semiconducteur suivant au moins l'une des revendications 1 à 8,
**caractérisé en ce que** la surface (13), du côté de la cathode, du corps (11) semiconducteur est contactée d'une manière conductrice de l'électricité par une première métallisation (19) de grande surface et **en ce que** la surface (18), du côté de la cathode, de la zone (15) de drift est contactée d'une manière conductrice de l'électricité par une deuxième métallisation (20) de grande surface.

10. Composant à semiconducteur suivant au moins l'une des revendications 1 à 9,
**caractérisé en ce que** le composant (10) à semiconducteur est constitué en diode (10) JBS, en transistor en couche d'arrêt ou en transistor MISFET.

# FIG 1

## FIG 2

## FIG 2A

EP 1 929 538 B1

# FIG 2B

# FIG 3

EP 1 929 538 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20040217375 A1

- US 20040046224 A1

**In der Beschreibung aufgeführte Nicht-Patentliteratur**

- **RANBIR SINGH et al.** High-Power 4H-SiC JBS-Rectifiers. *IEEE Transactions on Electron Devices,* 11. November 2002, vol. 49, 2054-2063